Europäisches Patentamt

European Patent Office

Office européen des brevets

(11) Veröffentlichungsnummer : **0 121 869**
**B1**

(12) ## EUROPÄISCHE PATENTSCHRIFT

(45) Veröffentlichungstag der Patentschrift :
01.10.86

(51) Int. Cl.⁴ : **H 01 L 31/18, H 01 L 31/02**

(21) Anmeldenummer : 84103478.8

(22) Anmeldetag : 29.03.84

(54) Verfahren zum Verhindern von Kurz- oder Nebenschlüssen in einer grossflächigen Dünnschicht-Solarzelle.

(30) Priorität : 02.04.83 DE 3312053

(43) Veröffentlichungstag der Anmeldung :
17.10.84 Patentblatt 84/42

(45) Bekanntmachung des Hinweises auf die Patenterteilung : 01.10.86 Patentblatt 86/40

(84) Benannte Vertragsstaaten :
BE DE FR IT

(56) Entgegenhaltungen :
EP-A- 0 000 715
US-A- 4 166 918
US-A- 4 197 141
US-A- 4 251 286
US-A- 4 318 938
APPLIED PHYSICS LETTERS, Band 34, Nr. 10, 15. Mai
1979, Seiten 699-701, New York, USA; S.K. GHANDHI
et al.: "Thin-film GaAs solar cells with grain-boundary edge passivation"

(73) Patentinhaber : Nukem GmbH
Rodenbacher Chaussee 6 Postfach 11 00 80
D-6450 Hanau 11 (DE)

(72) Erfinder : Hewig, Gert, Dr.
Sombornerstrasse 6
D-8755 Alzenau (DE)

(74) Vertreter : Stoffregen, Hans-Herbert, Dr. Dipl.-Phys. et
al
Patentanwälte Strasse & Stoffregen Salzstrasse 11a
Postfach 2144
D-6450 Hanau/Main 1 (DE)

## Beschreibung

Die Erfindung bezieht sich auf ein Verfahren zum Verhindern von Kurz- oder Nebenschlüssen in einer großflächigen Dünnschicht-Solarzelle umfassend ein Substrat mit elektrisch leitendem (ersten) Kontakt, auf den zumindest eine erste p- oder n-leitende Schicht und eine zweite n- oder p-leitende gegebenenfalls durch eine Schottkysche Sperrschicht zu ersetzende Schicht aufgebracht wird, die ihrerseits mit einem elektrisch leitenden (zweiten) Kontakt vorzugsweise in Form eines Gitters versehen wird.

Solarzellen, die einen diodenartige Struktur zeigen, können aus einkristallinen oder amorphen Substanzen aufgebaut sein. Beispielhaft sei in diesem Zusammenhang auf die US-A-40 64 521 oder die EP-A-0 000 715 verwiesen, in denen Dünnschicht-Solarzellen beschrieben werden, die aus amorphen Silizium bzw. Cadmium-sulfid-Kupfersulfid bestehen. Dünnschicht-Solarzellen bestehen grundsätzlich aus einem Substrat, auf das ein erster (rückwärtiger) metallischer Kontakt aufgebracht wird, auf den wiederum zumindest eine p- oder eine n-leitende dünne Schicht und auf diese eine n-leitende oder p-leitende zweite dünne Schicht aufgebracht werden. Die oberste Schicht wird sodann erneut mit einem elektrisch leitenden zweiten Kontakt versehen, der ein Metallgitter oder eine transparente leitfähige Schicht darstellen kann. Schließlich wird der zweite elektrische Kontakt durch zum Beispiel ein Deckglas abgedeckt. Alternativ kann eine Dünnschicht-Solarzelle eine Schottkysche Sperrschicht aufweisen, die dann zwischen dem zweiten elektrisch leitenden Kontakt als Frontkontakt und alternativ einem n- oder p-Leiter vorliegt.

Um großflächige Solarzellen wirtschaftlich herstellen und einsetzen zu können, ist es erforderlich, daß die Solarzellen frei von Kurz- und Nebenschlüssen sind, die bei der Herstellung entstehen können. Ursächlich für die Kurz- und Nebenschlüsse ist, daß die auf den ersten elektrischen Kontakt aufgetragene erste dünne p- oder n-leitende Schicht Inhomogenitäten aufweisen kann, durch die eine leitende Verbindung zwischen rückwärtigem (ersten) und frontseitigem (zweiten) elektrischem Kontakt erfolgt oder aber eine unvollkommene Sperrschicht sich ausbildet, wodurch die Diodenwirkung beeinträchtigt wird.

Die Inhomogenitäten können nun auf verschiedenartige Weise zustandekommen. Beim Aufdampfen der Schichten, insbesondere der ersten halbleitenden Schicht, können durch Staubpartikel auf dem Substrat bedingt Löcher entstehen. Diese Partikel schatten den ersten elektrischen Kontakt ab und verhindern somit beim Aufdampfen ein Aufwachsen der dünnen Schicht. Diese Störung des Wachstums äußert sich in Löchern der sonst zusammenhängenden Schicht. Ferner zeigt die Kinetik des Aufwachsens dünner Schichten, daß aufgrund des Prozesses der Clusterbildung während des Wachsens der ersten Monoschichten immer an einzelnen Stellen Löcher, sogenannte Pin-Holes oder Nadellöcher entstehen. Weiterhin kann eine Ausbildung von Kurz- oder Nebenschlüssen herbeiführenden Inhomogenitäten dann erfolgen, wenn eine Anätzung der dünnen Schichten erfolgt, da an Anhäufungen von Korngrenzen eine verstärkte Ätzung einsetzt, die gleichfalls zur Bildung von Löchern führen können. Diese zuvor geschilderten insbesondere durch Pin-Holes bestimmten Inhomogenitäten führen nun dazu, daß das zwischen p- und n-Leiter auszubildende innere Feld an dieser Stelle gar nicht zustande kommt, wodurch zu dem ansonsten ausgebildeten pn-Übergang an der Stelle des Pin-Holes ein Nebenschluß entsteht.

In der US-A-41 66 918 und der DE-A-32 23 432 wird nun ein Verfahren beschrieben, um Kurz-oder Nebenschlüsse in Solarzellen zu beseitigen. Dies erfolgt dadurch, daß an einer fertigen Solarzelle eine Sperrspannung angelegt wird. Dabei kann die Solarzelle gegebenenfalls in einen Elektrolyten getaucht werden. Das Heilen entsprechender Kurz- oder Nebenschlüsse erfolgt demzufolge erst nach der Fertigstellung einer Solarzelle. Man geht demzufolge den Weg, der bei der labormäßigen Herstellung von Solarzellen beschritten wird, nämlich erst dann die Funktionstüchtigkeit einer Solarzelle zu überprüfen und gegebenenfalls vorhandene Fehler zu heilen, wenn die Solarzelle fertiggestellt ist. Diese Überprüfung bzw. Heilung ist insbesondere bei einer großtechnischen Herstellung als kostenintensiv zu bezeichnen, da verständlicherweise nicht beliebig viele zu Störungen führende Inhomogenitäten geheilt werden können. Mit anderen Worten kann auch nach Anwendung des nach dem Stand der Technik bekannten Verfahrens der Fall eintreten, daß eine entsprechende Solarzelle nicht die erforderliche Leistung bringt.

Es ist daher Aufgabe der vorliegenden Erfindung, ein Verfahren der eingangs genannten Gattung derart weiterzubilden, daß bei einer großtechnischen Herstellung von großflächigen Dünnschicht-Solarzellen vor deren Fertigstellung sichergestellt ist, daß vorhandene Inhomogenitäten bei der fertiggestellten Solarzelle nicht zu Störungen führen. Die Aufgabe wird erfindungsgemäß dadurch gelöst, daß nach dem Auftragen der ersten und vor dem Auftragen der zweiten Schicht die von der ersten Schicht nicht wirksam bedeckten Bereiche des elektrisch leitenden ersten Kontakts passiviert werden. Man weicht demzufolge durch die erfindungsgemäße Lehre von dem von dem Stand der Technik vorgeschriebenen Weg ab, erst nach Fertigstellung der Solarzelle diese auf mögliche Fehler hin zu überprüfen und gegebenenfalls zu heilen. Demzufolge wird bereits vor Fertigstellung der Solarzelle die Weiche gestellt, ob eine Solarzelle funktionstüchtig ist oder nicht. Denn es darf nicht unberücksichtigt bleiben, daß nicht jede Anzahl von Inhomogenitäten geheilt werden können. Dies kann jedoch erfindungsgemäß unmittelbar nach Auftragen der ersten Schicht berücksichtigt werden.

Das Passivieren der lokalen Inhomogenitäten kann nun dadurch erfolgen, daß die nicht bedeckten Bereiche des in Form von vorzugsweise einer Metallschicht ausgebildeten elektrisch leitenden ersten Kontakts in den Halbleitertyp der ersten Schicht oder im Vergleich zu der ersten Schicht in eine Schicht höheren Widerstands, gegebenenfalls Isolator umgewandelt wird. Durch das Ausbilden entsprechender planarer Schichten werden erkennbar Kurz- oder Nebenschlüsse vermieden.

Hervorzuheben ist außerdem die Möglichkeit, daß in den nicht bedeckten Bereichen eine dünne Metallschicht eingebracht wird, die in einen Halbleiter des Typs der ersten Schicht oder im Vergleich zur ersten in eine Schicht höheren Widerstands umgewandelt wird. Insbesondere kann bei der Herstellung einer Dünnschicht-Solarzelle, deren elektrisch leitender Kontakt Silber, die erste Schicht als n-Leiter eine Cadmium-Sulfid-Schicht und die zweite Schicht vorzugsweise eine Kupfersulfidschicht ist, ein Heilen der Inhomogenitäten dadurch erfolgen, daß das von der Cadmium-Sulfid-Schicht nicht wirksam bedeckte Silber in Silbersulfid umgewandelt oder auf das Silber ein Metall wie zum Beispiel Aluminium abgeschieden wird, das vorzugsweise oxidiert oder sulfidiert wird.

Bei einer Dünnschicht-Solarzelle, bei der der elektrisch leitende erste Kontakt Au, die erste Schicht als p-Leiter eine $Cu_2S$-Schicht und die zweite Schicht vorzugsweise eine CdS-Schicht ist, kann die Passivierung dadurch erfolgen, daß das von der p-leitenden Schicht nicht wirksam bedeckte Gold in ein Halogenid oder Chalkogenid umgewandelt oder auf das Gold ein Metall wie zum Beispiel Cu abgeschieden wird, das anschließend oxidiert oder in ein Chalkogenid übergeführt wird.

Als besonders vorteilhaft darf das erfindungsmäße Verfahren im Zusammenhang mit der Herstellung von Tandemsolarzellensystemen zu bezeichnen sein, bei denen Solarzellen unterschiedlicher spektraler Empfindlichkeit übereinander angeordnet sind. Entsprechende Tandemsolarzellensysteme sind nach dem bekannten Verfahren zum Heilen von Kurz- oder Nebenschlüssen wirkungsvoll nicht zu passivieren. Hier schafft zum ersten Mal die erfindungsgemäße Lehre eine Möglichkeit, auch bei großtechnischer Herstellung von entsprechenden Tandemsolarzellensystemen sicherzustellen, daß die zum Einsatz gelangenden Systeme voll funktionstüchtig sind.

Weitere Einzelheiten, Vorteile und Merkmale der Erfindung sollen anhand der zeichnerischen Darstellungen verdeutlicht werden.

Es zeigen :
Figur 1   eine Dünnschicht-Solarzelle und
Figur 2   ein Tandemsolarzellensystem.

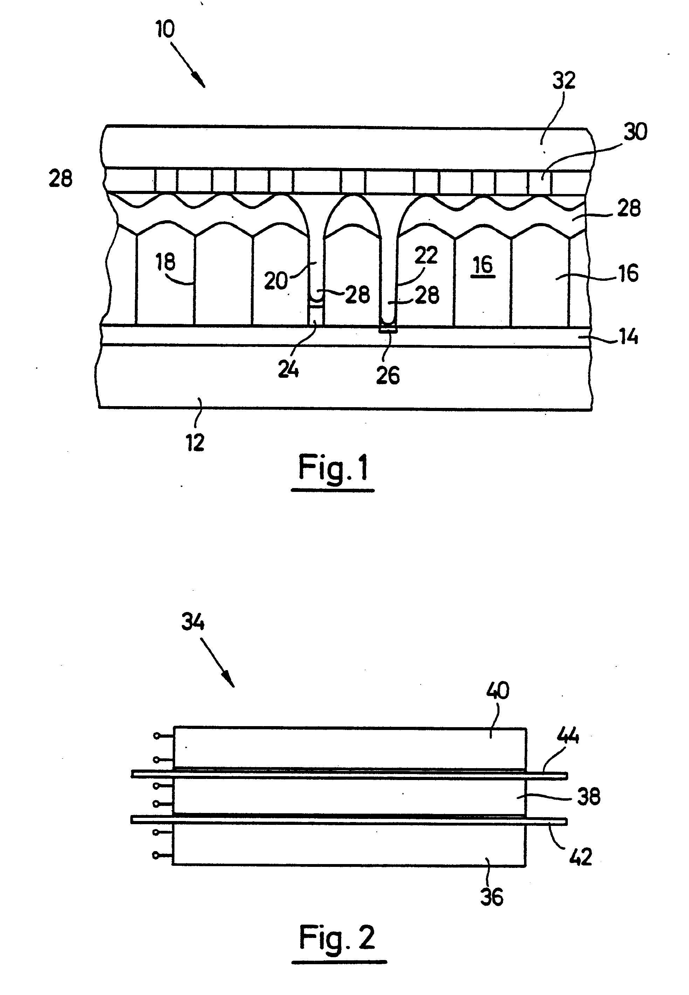

Die Durchführung des Verfahrens zur Verhinderung von Kurz- oder Nebenschlüssen bei großtechnisch hergestellten Solarzellen soll an einer in Fig. 1 beispielhaft dargestellten CdS/Cu₂S Solarzelle beschrieben werden. Bei einer entsprechenden Solarzelle 10 wird zunächst auf eine Grundplatte, die vorzugsweise aus einem Substratglas 12 besteht, das seinerseits mit einem Haftvermittler wie zum Beispiel aufgedampftes Chrom versehen ist, eine Schicht aus Silber 14 durch Aufdampfen aufgetragen. Auf diese als elektrischer Kontakt dienende Metallschicht wird eine Schicht aus Cadmiumsulfid 16 von beispielsweise 30 μm Dicke durch zum Beispiel Sintern, pyrolytische Zersetzung oder Aufdampfen aufgebracht. Je nach Herstellungsprozeß kann die so entstandene Cadmiumsulfid-Schicht 16 noch naßtechnisch oder plasmatechnisch angeätzt werden, um zum Beispiel Ansammlungen von Korngrenzen 18 auszuätzen und die Reflexion der Schicht zu verringern.

Allen Verfahren ist jedoch gemeinsam, daß in der Cadmiumsulfid-Schicht 16 Inhomogenitäten vorzugsweise in Form von Pin-Holes 20, 22 auftreten, die zwar mikroskopisch klein sein können, aber in jedem Fall vorhanden sind. Um die Inhomogenitäten unwirksam werden zu lassen, wird nach Auftragen der Cadmiumsulfid-Schicht 16 der rückseitige metallische Kontakt 14, der zum Beispiel in den Pin-Holes nicht von der Halbleiterschicht 16 bedeckt ist, vorzugsweise

— durch geeignete Lösungsmittel an der Stelle der Pin-Holes aufgelöst, zum Beispiel durch Eintauchen in Salpetersäure,

— in S-Ionenhaltige Lösungen getaucht, so daß die Oberfläche der zum Beispiel aus Silber bestehenden metallischen Schicht 14 in n-leitendes $Ag_2S$ umgewandelt wird (zum Beispiel durch Eintauchen in $(NH_4)_2S$-Lösung). Das so entstandene $Ag_2S$ weist dabei vorzugsweise eine Dicke von 0,1 bis 1 μm auf,

— in einer $H_2S$-Atmosphäre behandelt, wodurch das Silber ebenfalls in $Ag_2S$ umgewandelt wird,

— plasmatechnisch in S-Ionenhaltiger Atmosphäre behandelt, so daß das Silber in $Ag_2S$ umgewandelt wird und die so entstandene Schicht vorzugsweise eine Stärke von 0,1 bis 1 μm aufweist,

— mittels galvanischen Abscheidens von Aluminium in den Pin-Holes aus zum Beispiel einer Aluminiumchlorid-, -acetat- oder -sulfat-Lösung behandelt, wobei die abgeschiedene Aluminiumschicht vorzugsweise in etwa 01, bis 1 μm dick ist. Das so abgeschiedene Aluminium wird anschließend durch Eloxieren in $Al_2O_3$ umgewandelt, so daß die Metallschicht mit einer isolierenden Schicht bedeckt ist. Die Dicke der $Al_2O_3$-Schicht kann dabei durch die geeignete Wahl der angelegten Spannung während des Eloxierens vorzugsweise 1 μm dick gewählt werden.

Sobald die beispielhaft wiedergegebene Art der Heilung von Inhomogenitäten erfolgt ist (24, 26), wird ein Kupfersulfid-Schicht 28 als p-Leiter zumeist topotaktisch erzeugt, d. h., die Cadmiumsulfid-Schicht 16 wird in eine Kupferionenlösung eingetaucht, wobei die Cadmiumsulfid-Schicht 16 an der Oberfläche in eine Kupfersulfid-Schicht 28 übergeführt wird. Die Kupfersulfid-Schicht 28 kann eine Größenordnung von beispielsweise 0,2 μm Dicke besitzen. Auf die Kupfersulfid-Schicht 28 wird noch als frontseitiger metallischer Kontakt eine Kupferschicht 30 aufgetragen, die Netzstruktur aufweisen kann. Anschließend wird die Solarzelle mit einer transparenten Schicht 32 abgedeckt. Die so entsprechend der erfindungsgemäßen Lehre großtechnisch herstellbaren Dünnschicht-Solarzellen 10 weisen ein hohe Güte auf, die einen wartungsarmen Betrieb gewährleisten.

Das erfindungsgemäße Verfahren kann auch bei einem Tandem-Solarzellensystem 34 gemäß Fig. 2 Verwendung finden. Ein solches Tandem-Solarzellensystem 34 besteht aus übereinander angeordneten Solarzellen 36, 38, 40, die durch Zwischenschichten 42 und 44 galvanisch voneinander getrennt sind. Ist im Ausführungsbeispiel das Tandem-Solarzellensystem 34 nur mit drei Solarzellen unterschiedlicher sprektaler Empfindlichkeit dargestellt, so können selbstverständlich auch mehr Solarzellen zu einem entsprechenden System geschaltet werden. Durch das erfindungsgemäße Verfahren bei der Herstellung der einzelnen zu dem System zusammengesetzten Solarzellen ist erkennbar der Vorteil gegeben, daß die Gewähr für eine Funktionstüchtigkeit des Systems sehr groß ist, da jede Solarzelle auf einfache, jedoch sichere Weise passiviert werden kann, so daß Kurz- und Nebenschlüsse unterbunden werden.

Das zuvor an einer Dünnschicht-Solarzelle bzw. an einem Tandem-Solarzellensystem beschriebene erfindungsgemäße Verfahren läßt sich selbstverständlich auch bei Solarzellen anwenden, bei denen herstellungstechnisch zuerst eine erste vorderseitige (lichtquellenseitige) transparente leitfähige Schicht zum Beispiel $SnO_x$ oder ITO erzeugt wird.

Ferner seien beispielhaft np-Solarzellen angegeben, die bei Anwendung des erfindungsgemäßen Verfahrens eine zuverlässige und wartungsarme Funktionstüchtigkeit zeigen. Es handelt sich dabei um Solarzellen wie CdS/CdTe, CdS/InP, $CdS/CnInSe_2$, $CdS/CnInS_2$, CdS/ZnTe, $CdS/Cn_2S$. Ferner sind auch ternäre Systeme möglich wie zum Beispiel $Cd_{1-x}Zn_xS$.

Schließlich seien noch einmal wesentliche Vorteile hervorgehoben, die auf das erfindungsgemäße Verfahren zurückzuführen sind :

a) großtechnische Fertigung von Dünnschicht-Solarzellen hoher Güte,

b) hohe Qualitätssicherung durch das Vermeiden on Kurz- und Nebenschlüssen,

c) ein überaus einfaches, jedoch sicheres Verfahren,

d) keine wesentliche kostenmäßige Verteuerung der Herstellung von Dünnschicht-Solarzellen.

**Patentansprüche**

1. Verfahren zum Verhindern von Kurz- oder Nebenschlüssen in einer großflächigen Dünnschicht-Solarzelle, umfassend ein Substrat (12) mit elektrisch leitendem ersten Kontakt (14), auf den zumindest eine erste p- oder n-leitende Schicht (16) und eine zweite n- oder p-leitende gegebenenfalls durch eine Schottkysche Sperrschicht zu ersetzende Schicht (28) aufgebracht wird, die ihrerseits mit einem elektrisch leitenden zweiten Kontakt vorzugsweise in Form eines Gitters (30) versehen wird, dadurch gekennzeichnet, daß nach dem Auftragen der ersten (16) und vor dem Auftragen der zweiten Schicht (28) die von der ersten Schicht (16) nicht wirksam bedeckten Bereiche (20, 22) des elektrisch leitenden ersten Kontakts passiviert werden (24, 26).

2. Verfahren nach Anspruch 1, dadurch gekennzeichnet, daß die nicht bedeckten Bereiche in einen Halbleitertyp der ersten Schicht oder im Vergleich zu der ersten Schicht in eine Schicht höheren Widerstands, oder einen Isolator umgewandelt werden.

3. Verfahren nach Anspruch 1, dadurch gekennzeichnet, daß in den Bereichen eine Metallschicht eingebracht wird, die in einen Halbleiter des Typs der ersten Schicht oder im Vergleich zur ersten in eine Schicht höheren Widerstands oder Isolator umgewandelt wird.

4. Verfahren nach Anspruch 1 mit einer Dünnschicht-Solarzelle, bei der der elektrisch leitende erste Kontakt Silber, die erste Schicht als n-Leiter eine Cadmiumsulfidschicht und die zweite Schicht vorzugsweise eine Kupfersulfidschicht ist, dadurch gekennzeichnet, daß das von der Kadmiumsulfidschicht nicht wirksam bedeckte Silber in silbersulfid umgewandelt oder auf das Silber ein Metall wie zum Beispiel Aluminium abgeschieden wird, das vorzugsweise oxidiert oder sulfidiert wird.

5. Verfahren nach Anspruch 1 mit einer Dünnschicht-Solarzelle, bei der der elektrisch leitende erste Kontakt Gold, die erste Schicht als p-Leiter eine $Cu_2S$-Schicht und die zweite Schicht vorzugsweise eine CdS-Schicht ist, dadurch gekennzeichnet, daß das von der p-leitenden Schicht nicht wirksam bedeckte Gold in ein Halogenid oder Chalkogenid umgewandelt oder auf das Gold ein Metall wie zum Beispiel Kupfer abgeschieden wird, das anschließend oxidiert oder in ein Chalkogenid übergeführt wird.

6. Verwendung des im Anspruch 1, beschriebenen Verfahrens bei der Herstellung von Tandemsolarzellensystemen.

**Claims**

1. A method or preventing short-circuits or shunts in a large-area, thin-film solar cell, said method comprising the steps of sequentially applying, to a substrate (12) comprising a first conductive electrical contact (14), at least one first layer comprising a p-type or n-type conductive layer (16) and a second layer comprising an n-type of p-type conductive layer or a Schottky barrier layer (28), said second layer being provided with a second conductive electrical contact preferably in the form of a lattice (30), characterized in that, after applying the first layer (16) and before applying the second layer (28) there is practised the step of passivating those areas (20, 22) of the first conductive electrical contact (24, 26) which are not effectively covered by the first layer.

2. A method according to claim 1 characterized in that, the step of passivating the uncovered areas is practiced by converting said uncovered areas into a semiconductor of the same type as the first layer or, as compared to the first layer, into a layer of higher resistance, or into an insulator.

3. A method according to claim 1 characterized in that, the step of passivating the uncovered areas is practiced by depositing a metal layer in the uncovered areas, which metal layer is then converted into a semiconductor of the same type as the first layer or, as compared to the first layer, into a layer of higher resistance, or into an insulator.

4. A method according to claim 1 with a thin-layer solar cell wherein the first conductive electrical contact is silver, the first layer is an n-type cadmium sulfide layer, and the second layer is preferably a copper sulfide layer characterized in that, the silver not effectively covered by the said cadmium sulfide layer is converted into silver sulfide, or in that a metal such as aluminium is deposited onto the silver, said deposited metal to preferably be oxidized or sulfidized.

5. A method according to claim 1 with a thin-layer solar cell wherein the first conductive electrical contact is gold, the first layer is an p-type $Cu_2S$ layer, and the second layer is preferably a CdS layer, characterized in that, the gold not effectively covered by the conductive p-type layer is converted into a halogenide or a chalcogenide, or in that a metal such as copper is deposited onto the gold, said deposited metal to then be oxidized or converted into a chalcogenide.

6. Use of the process described in claim 1 in the production of a plurality of tandem-solar cell systems.

**Revendications**

1. Procédé pour éviter des courts-circuits ou des faux contacts dans une cellule solaire en couches minces de grande surface, comprenant un support (12) avec un premier contact (14) électrique qui reçoit au moins une première couche conductrice (16) de type p ou de type n et une seconde couche conductrice de type n ou de type p remplacée le cas échéant par une couche de barrage de type schottky (28) qui est munie elle-même d'un second contact électrique de préférence sous la forme d'une grille (30), caractérisé en ce qu'après avoir appliqué la première couche (16) et avant d'appliquer la seconde couche (28) on effectue la passivation des zones (20, 22) efficaces non recouvertes par la première couche (61) du premier contact électrique (24, 26).

2. Procédé selon la revendication 1, caractérisé en ce que les zones non recouvertes sont transformées en un semi-conducteur du type de celui de la première couche ou en une résistance plus élevée que celle de la première couche, ou en un isolant.

3. Procédé selon la revendication 1, caractérisé en ce que l'on prévoit une couche métallique dans les zones qui sont transformées en un semi-conducteur du type de celui de la première couche, ou en une résistance plus élevée que celle de la première couche, ou en un isolant.

4. Procédé selon la revendication 1, avec une cellule solaire en couche mince dans laquelle le premier contact électrique est en argent, la première couche est une couche de sulfure de cadmium comme conducteur de type n et la seconde couche est de préférence une couche de sulfure de cuivre, caractérisé en ce que l'argent non recouvert de manière efficace par la couche de sulfure de cadmium est transformée en sulfure d'argent ou encore on dépose sur l'argent un métal comme par exemple de l'aluminium que l'on oxyde ou que l'on transforme de préférence en un sulfure.

5. Procédé selon la revendication 1, pour une cellule solaire en couche mince, dans laquelle le premier contact électrique est de l'or, la première couche est une couche $Cu_2$-S à conduction de type p et la seconde couche est de préférence une couche CdS, caractérisé en ce que l'or non recouvert de façon efficace par la couche à conduction de type p est transformée en un halogénure ou en un chalcogénure, ou encore on dépose sur l'or un métal comme par exemple du cuivre que l'on oxyde ou que l'on transforme en un chalcogénure.

6. Application du procédé décrit à la revendication 1, pour la réalisation de système de piles solaires tandem.

**Fig.1**

**Fig. 2**